# EUROPÄISCHE PATENTANMELDUNG

(11) **EP 0 787 625 A2**
(43) Veröffentlichungstag der Anmeldung: **06.08.1997**
(21) Anmeldenummer: 97101191.1
(22) Anmeldetag: 27.01.1997
(51) Int. Cl.: B60R 16/02

(54) **Elektrischer Signalgeber**

(30) Priorität: 30.01.1996 DE 19603197
(71) Anmelder: Leopold Kostal GmbH & Co. KG, 58507 Lüdenscheid (DE)
(72) Erfinder: Steiling, Rainer, 58515 Lüdenscheid (DE); Rimke, Kersten, 58849 Herscheid (DE); Garneyer, Stefan, 58097 Hagen (DE)

(57) **Zusammenfassung**

Es wird eine für ein Kraftfahrzeug vorgesehener Signalgeber mit einer zur Detektion von verschiedenen, hintereinander liegenden Positionen eines verstellbares Kraftfahrzeug-Teiles vorgesehenen Sensoreinrichtung vorgeschlagen, bei der zur sicheren Erkennung von einer Vielzahl von Positionen das verstellbare Teil mit einem an einer Halterung vorhandenen, entsprechend verstellbaren magnetischen Auslöseorgan verbunden ist, welches mehrere sich in Verstellrichtung erstreckende Magnetspuren mit für jede Magnetspur sich abwechselnder und damit eine Kodierung sicherstellender Polarität aufweist, wobei den Magnetspuren des Auslöseorgans jeweils zumindest ein magnetfeldempfindliches Bauelement zugeordnet ist und wobei die magnetfeldempfindlichen Bauelemente mit einer die jeweiligen Zustände derselben erfassenden und logisch auswertenden Schaltungsanordnung zur entsprechenden Beeinflussung eines zugeordneten Aggregates verbunden sind.

## Beschreibung

Die vorliegende Erfindung geht von einem gemäß dem Oberbegriff des Hauptanspruches konzipierten, in Kraftfahrzeugen zum Einsatz gelangenden elektrischen Signalgeber aus.

Derartige elektrische Vorrichtungen sind insbesondere dafür vorgesehen, um in Abhängigkeit der jeweiligen Position eines verstellbaren Kraftfahrzeug-Teiles, z.B. eines Stellgliedes eines Automatikgetriebes, ein entsprechendes Signal zu liefern und zwar, um damit zugeordnete Aggregate - wie das Automatikgetriebe - entsprechend zu beeinflussen.

Durch die DE 41 23 480 A1 ist ein elektrischer Signalgeber bekanntgeworden, durch den mit Hilfe eines magnetischen Bauteils und eines davon durch eine Trennwand getrennten magnetfeldempfindlichen Bauelementes ein auf die Position eines verstellbaren Kraftfahrzeug-Teils - wie z.B. des Schaltnockens eines Kraftfahrzeuggetriebes - abgestimmtes Signal geliefert wird. Mit diesem Signalgeber lassen sich aber nicht mehrere hintereinander liegende Positionen erkennen.

Der vorliegenden Erfindung liegt die Aufgabe zugrunde, einen elektrischen Signalgeber der eingangs erwähnten Art derart weiterzubilden, daß eine Vielzahl von Positionen und Zwischenstellungen sicher erkannt werden können.

Erfindungsgemäß wird die Aufgabe durch die im kennzeichnenden Teil des Hauptanspruches angegebenen Merkmale gelöst.
Vorteilhaft bei einem derartigen Aufbau eines elektrischen Signalgebers ist, daß jede Positionsveränderung exakt erfaßt wird, so daß sehr feinfühlige Steuerungen z.B. eines nachgeschalteten Kraftfahrzeug-Automatikgetriebes in einwandfreier Art und Weise durchgeführt werden können.

Weitere besonders günstige Ausgestaltungen des erfindungsgemäßen Gegenstandes sind in den Unteransprüchen angegeben und werden anhand eines in der Zeichnung dargestellten Ausführungsbeispieles näher erläutert. Dabei zeigen
- Fig. 1a: die wesentlichen Teile eines elektrischen Signalgebers im Schnitt gemäß Linie B-B der Fig. 1b
- Fig. 1b: die Einzelheiten des Signalgebers im Schnitt gemäß Linie A-A der Fig. 1a
- Fig. 2a: eine für eine willkürlich gewählte Kodierung erforderliche Anordnung der Magnetpole der vier in Fig. 1 vorhandenen Magnetspuren
- Fig. 2b: die zur Fig. 2a gehörende, aus der Anordnung der Magnetpole resultierende Signaltabelle

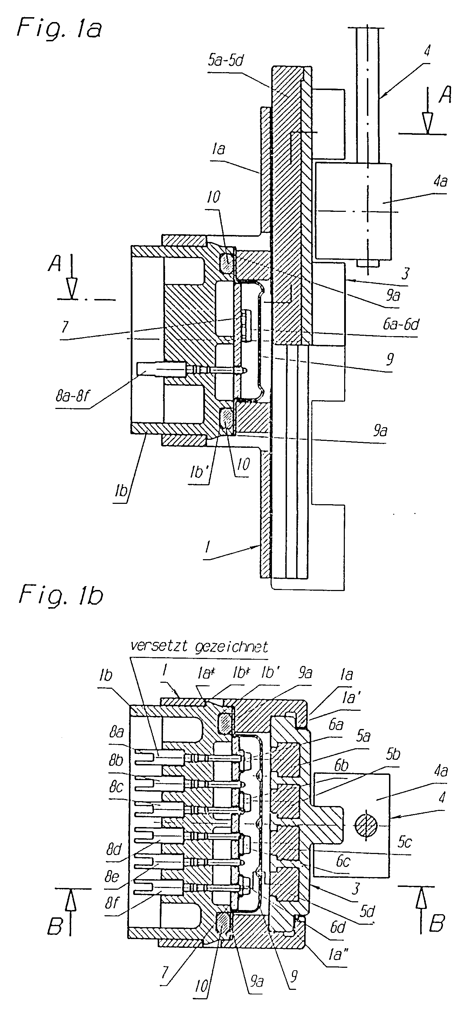

Wie aus Fig. 1 hervorgeht, ist in einem Kraftfahrzeug eine Halterung 1 ortsfest angeordnet, die sich im wesentlichen aus zwei vorzugsweise aus Kunststoff bestehenden, durch Clipsmittel 1a*/1b* miteinander verbundenen Gehäuseteilen 1a,1b zusammensetzt. An dem einen Gehäuseteil 1a ist ein als Schieber ausgebildetes Auslöseorgan 3 längsverschiebbar in zwei daran vorhandenen Führungsnuten 1a',1a'' gehalten. Das Auslöseorgan 3 wird dabei über ein vorzugsweise manuell beeinflußbares, insbesondere als Wählhebel eines Automatikgetriebes ausgebildetes Stellglied 4 bewegt, welches sich über ein Kopplungsglied 4a mit dem Auslöseorgan 3 in Eingriff befindet.

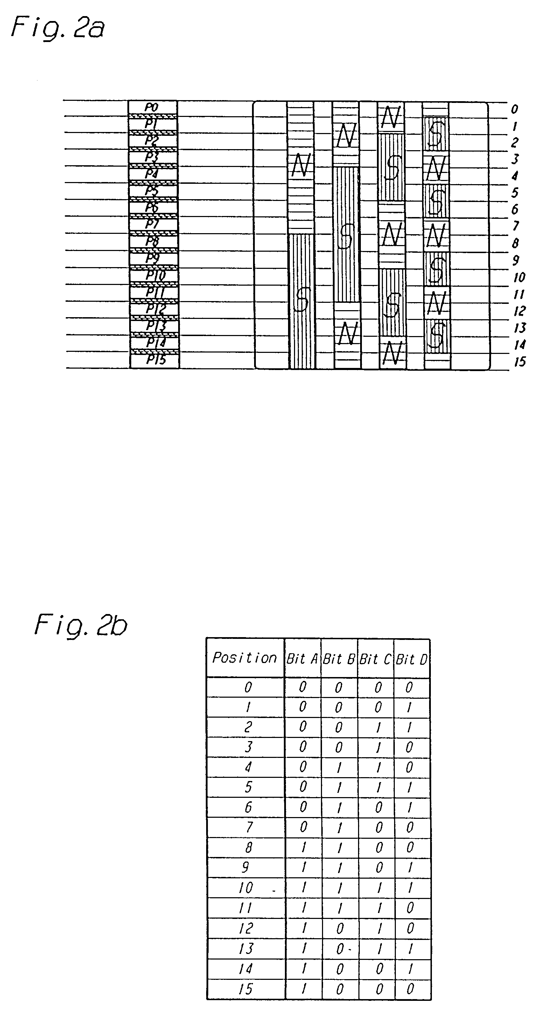

In bzw. an dem Auslöseorgan 3 sind nunmehr in Verschieberichtung desselben sich erstreckende, aus dauermagnetischem Werkstoff gebildete, gleich lang ausgeführte Magnetspuren 5a-5d angeordnet, die parallel zueinander ausgerichtet sind. Die Magnetspuren 5a-5d sind aus verschieden lang ausgeführten Magnetpol-Abschnitten N/S gebildet, wobei in jeder Magnetspur eine alternierende, z.B. gemäß der in Fig. 2a dargestellten Anordnung ausgeführte Polarität vorhanden ist, woraus die in der Tabelle nach Fig. 2b angegebenen Signale resultieren. Mit dieser auf einer sogenannten 4-bit Kodierung beruhenden Signalgabe lassen sich eindeutig vorgegebene Positionen bzw. Zwischenstellungen erkennen.

Diese Signalgabe wird mittels der an dem anderen Gehäuseteil 1b vorhandenen magnetfeldempfindlichen, den Magnetspuren 5a-5d zugeordneten Bauelemente 6a-6d erzeugt, die an einer Leiterplatte 7 in Abständen voneinander angeordnet sind, die den Abständen der Magnetspuren 5a-5d entsprechen.
Die magnetfeldempfindlichen, vorzugsweise auf der Ausnutzung des Hall-Effektes basierenden Bauelemente 6a-6d sind mit auf der Leiterplatte 7 vorhandenen, der Einfachheit halber nicht dargestellten Leiterbahnen verbunden, an die auf der anderen Seite der Leiterplatte vorgesehene, senkrecht zur Leiterplatte ausgerichtete langgestreckte Anschlußkontaktelemente 8a-8f einerseits angeschlossen sind, mit denen andererseits Leitungen einer ebenfalls der Einfachheit halber nicht dargestellten Schaltungsanordnung zur Auswertung der an den Ausgängen der Bauelemente jeweils anstehenden Signale verbunden sind. Über diese Schaltungsanordnung kann dann ein zugeordnetes Aggregat - wie z.B. das Kraftfahrzeug-Automatikgetriebe - entsprechend beeinflußt werden.

In dem Fall, daß der Signalgeber einem Kraftfahrzeug-Automatikgetriebe zugeordnet wird, ist es günstig, die Bauelemente 6a-6d in einer an der Halterung 1 vorhandenen, hermetisch geschlossenen Gehäusekammer anzuordnen und von den Magnetspuren 5a-5d durch eine Trennwand 9 zu trennen. Somit kann die Halterung 1 das Automatikgetriebe eingebracht werden, wobei dieselbe im Innenraum des Automatikgetriebes, d.h. unter Öl angeordnet ist. Zur Abdichtung der Gehäusekammer ist dabei ein an dem anderen Gehäuseteil 1b in einer dort vorhandenen umlaufenden Nut 1b' gehaltener O-Ring 10 aus elastomerem Material vorgesehen, der andererseits dem äußeren Rand 9a der Trennwand 9 umlaufend zugeordnet ist.

## Patentansprüche

1. Elektrischer Signalgeber mit einer an einer Halterung vorhandenen Sensoreinrichtung zur Detektion der von einem in verschiedene, hintereinander liegende Stellungen bewegbaren insbesondere das Stellglied eines Automatikgetriebes darstellenden Teil eines Kraftfahrzeuges jeweils eingenommenen Position, **dadurch gekennzeichnet**, daß das bewegbare Teil (4) mit einem an der Halterung (1) vorhandenen, entsprechend verstellbaren magnetischen Auslöseorgan (3) verbunden ist, das mehrere sich in Verstellrichtung erstreckende Magnetspuren (5a-5d) mit für jede Magnetspur sich abwechselnder und damit eine Kodierung sicherstellenden Polarität (N/S) aufweist, daß den Magnetspuren (5a-5d) des Auslöseorgans (3) jeweils zumindest ein magnetfeldempfindliches Bauelement (6a-6d) zugeordnet ist und daß die magnetfeldempfindlichen Bauelemente (6a-6d) mit einer die jeweiligen Zustände derselben erfassenden und logisch auswertenden Schaltungsanordnung zur entsprechenden Beeinflussung eines zugeordneten Aggregates verbunden sind.

2. Elektrischer Signalgeber nach Anspruch 1, dadurch gekennzeichnet, daß zwecks Detektion von 2ⁿ Positionen n Magnetspuren (5a-5d) und n magnetfeldempfindliche Bauelemente (6a-6d) vorhanden sind.

3. Elektrischer Signalgeber nach einem der Ansprüche 1 oder 2, dadurch gekennzeichnet, daß im Zusammenhang mit einem Kraftfahrzeug-Automatikgetriebe das Auslöseorgan (3) vier Magnetspuren (5a-5d) aufweist und daß jeder Magnetspur ein den Hall-Effekt ausnutzendes magnetfeldempfindliches Bauelement (6a-6d) zugeordnet ist.

4. Elektrischer Signalgeber nach einem der Ansprüche 1 bis 3, dadurch gekennzeichnet, daß die magnetfeldempfindlichen Bauelemente (6a-6d) in einer hermetisch geschlossenen Gehäusekammer der Halterung (1) angeordnet sind.

5. Elektrischer Signalgeber nach Anspruch 4, dadurch gekennzeichnet, daß die magnetfeldempfindlichen Bauelemente (6a-6d) und die am Auslöseorgan (3) vorhandenen Magnetspuren (5a-5d) durch eine der Gehäusekammer zugeordnete Trennwand (9) hermetisch voneinander getrennt sind und daß die magnetfeldempfindlichen Bauelemente (6a-6d) und das Auslöseorgan (3) jeweils in der Nähe der Trennwand (9) beiderseits derselben angeordnet sind.

6. Elektrischer Signalgeber nach einem der Ansprüche 1 bis 5, dadurch gekennzeichnet, daß die Magnetspuren (5a-5d) parallel zueinander ausgerichtet und an dem als Schieber ausgebildeten Auslöseorgan (3) gehalten sind, das einerseits der Trennwand (9) in dort vorgesehenen Führungsnuten (1a',1a'') der Halterung (1) angeordnet ist.

7. Elektrischer Signalgeber nach einem der Ansprüche 1 bis 6, dadurch gekennzeichnet, daß die Halterung (1) im wesentlichen aus zwei aus Kunststoff hergestellten Gehäuseteilen (1a,1b) besteht, zwischen denen die Trennwand (9) form- und/oder kraftschlüssig gehalten ist und daß an dem einen Gehäuseteil (1a) das die Magnetspuren aufweisende, als Schieber ausgebildete Auslöseorgan (3) bewegbar gehalten ist.

8. Elektrischer Signalgeber nach Anspruch 7, dadurch gekennzeichnet, daß der Trennwand (9) ein einerseits im Bereich ihres Randes (9a) umlaufend vorhandenes, andererseits an dem einen der beiden Gehäuseteile (1b) zur Anlage kommendes elastomeres Dichtmittel (10) zugeordnet ist.

9. Elektrischer Signalgeber nach Anspruch 8, dadurch gekennzeichnet, daß das Dichtmittel (10) als ein in einer umlaufenden Ausnehmung des anderen der beiden Gehäuseteile (1b) angeordneter O-Ring ausgebildet ist.

10. Elektrischer Signalgeber nach einem der Ansprüche 1 bis 9, dadurch gekennzeichnet, daß die magnetfeldempfindlichen Bauelemente (6a-6d) über an der Halterung (1) vorhandene elektrische Leiter mit einer einerseits an der Schaltungsanordnung angeschlossenen elektrischen Verbindungsleitung andererseits verbunden sind.

11. Elektrischer Signalgeber nach Anspruch 10, dadurch gekennzeichnet, daß die magnetfeldempfindlichen Bauelemente (6a-6d) auf einer der beiden Oberflächen einer im wesentlichen parallel zur Trennwand (9) sich erstreckenden Leiterplatte (7) gehalten und mit daran vorgesehenen, einerseits an der Verbindungsleitung angeschlossenen Leiterbahnen andererseits elektrisch verbunden sind.

12. Elektrischer Signalgeber nach Anspruch 11, dadurch gekennzeichnet, daß den Leiterbahnen der Leiterplatte (7) mit der Verbindungsleitung kooperierende Anschlußkontaktelemente (8a-8f) zugeordnet sind, die sich im wesentlichen auf der anderen der beiden Oberflächen befinden und sich senkrecht zu derselben erstrecken.

13. Elektrischer Signalgeber nach einem der Ansprüche 1 bis 12, dadurch gekennzeichnet, daß die Trennwand (9) aus einem für die magnetischen Felder der Magnetspuren (5a-5d) durchlässigen Material besteht.

14. Elektrischer Signalgeber nach einem der Ansprüche 1 bis 13, dadurch gekennzeichnet, daß die Trennwand (9) aus einem aus Messing hergestellten Formblech besteht

15. Elektrischer Signalgeber nach einem der Ansprüche 1 bis 14, dadurch gekennzeichnet, daß die Kodierung durch Wahl der Länge der den Magnetspuren (5a-5d) zugehörigen Magnetpole (N/S) auf die jeweilige Anwendung abstimmbar ist.
